Europäisches Patentamt

European Patent Office

Office européen des brevets

(19)

(11) **EP 0 460 263 B1**

(12) **EUROPÄISCHE PATENTSCHRIFT**

(45) Veröffentlichungstag und Bekanntmachung des
Hinweises auf die Patenterteilung:
**28.08.1996   Patentblatt 1996/35**

(51) Int Cl.⁶: **H03F 3/30**, H03F 1/32

(21) Anmeldenummer: **90110765.6**

(22) Anmeldetag: **07.06.1990**

(54) **Lineare CMOS-Ausgangsstufe**

Linear CMOS output stage

Etage de sortie linéaire réalisé en technologie CMOS

(84) Benannte Vertragsstaaten:
**DE FR GB IT NL**

(43) Veröffentlichungstag der Anmeldung:
**11.12.1991   Patentblatt 1991/50**

(73) Patentinhaber: **Deutsche ITT Industries GmbH
D-79108 Freiburg (DE)**

(72) Erfinder: **Theus, Ulrich, Dr.-Ing.
D-7803 Gundelfingen (DE)**

(56) Entgegenhaltungen:
**US-A- 4 480 230            US-A- 4 803 441
US-A- 4 897 612**

Anmerkung: Innerhalb von neun Monaten nach der Bekanntmachung des Hinweises auf die Erteilung des europäischen
Patents  kann jedermann beim Europäischen Patentamt gegen das erteilte europäische Patent Einspruch einlegen.
Der Einspruch ist schriftlich einzureichen und zu begründen. Er gilt erst als eingelegt, wenn die Einspruchsgebühr
entrichtet worden ist. (Art. 99(1) Europäisches Patentübereinkommen).

**Beschreibung**

Die Verstärkung von Ausgangsstufen in Gegentakttechnik ist im allgemeinen sowohl von der Signalfrequenz als auch mehr oder weniger von der Aussteuerung abhängig. Im Extremfall ergeben sich bei kleinen Aussteuerungen, insbesondere im B-Betrieb, die sogenannten Übernahmeverzerrungen. Die aussteuerungsabhängige Verstärkung kann sich nachteilig auf die Verarbeitung von Audio-, Meß- oder sonstiger Signale auswirken, wenn dabei auf möglichst geringe Verzerrungen geachtet werden soll. Durch derartige Verstärkungsänderungen der Ausgangsstufe wird beispielsweise der wirksame Gegenkopplungsgrad von Operationsverstärkern aussteuerungsabhängig, so daß die exakte Linearität über den gesamten Aussteuerungsbereich nicht gewährleistet bleibt.

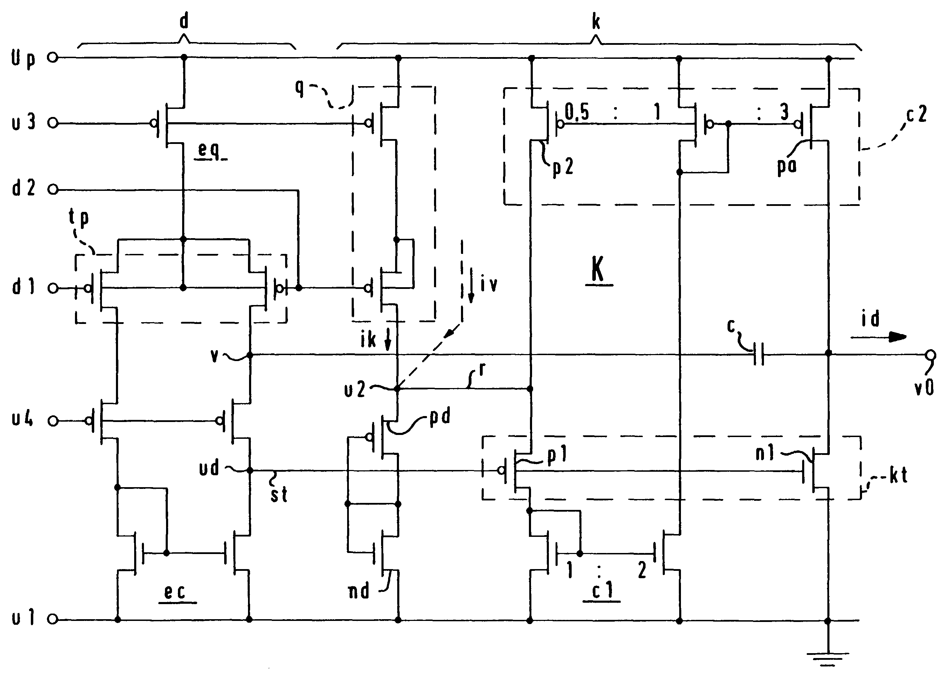

Aus IEEE Journal of Solid-State Circuits, Bd. SC-22, Nr. 6, Dezember 1987, Seite 1082-1089, insbesondere Seite 1085 mit der Fig.6a und der Fig.6b, ist es bekannt, bei CMOS-Ausgangsstufen die quadratischen Kennlinien eines komplementären Feldeffekt-Transistorpaares so miteinander zu kombinieren, daß die Verstärkung der Ausgangsstufe aussteuerungsunabhängig wird. Hierzu wird die quadratische Strom-Spannungskennlinie $I_{DS} = \beta(U_{GS} - U_T)^2$ eines n- und eines p-Kanal-Transistors ausgenutzt. Dabei ist: $I_{DS}$ = Drain-Source-Strom, $U_{GS}$ = Gate-Source-Spannung, $U_T$ = konstanter Transistor-Schwellenwert, $\beta$ = Transistor-Steilheitsparameter. Das komplementäre Transistorpaar wird dabei am jeweiligen Gate-Anschluß von einem gemeinsamen Steuerpotential angesteuert, wobei der Source-Anschluß des jeweiligen Transistors auf einem ersten bzw. zweiten Festpotential liegt. Die Lage dieser Festpotentiale wird dabei so gewählt, daß beide Transistoren im gesamten Aussteuerungsbereich die jeweilige quadratische Strom-Spannungskennlinie nicht verlassen, also in ihrem jeweiligen Sättigungsbereich bleiben. Man spricht daher auch von einem A/B-Gegentaktbetrieb. Indem die beiden Ausgangsströme des komplementären Transistorpaares über eine Stromspiegelanordnung auf eine Stromdifferenzstufe geführt werden, wird dort hochohmig ein Differenzstrom erzeugt, der den gewünschten aussteuerungsunabhängigen proportionalen Stromverlauf aufweist. Mittels eines Lastwiderstandes kann dieser Differenzstrom in ein Spannungssignal umgewandelt werden, beispielsweise bei einem Operationsverstärker.

Durch die gemeinsame Ansteuerung des komplementären Transistorpaares wird der Drain-Strom des einen Transistors verkleinert und der des anderen Transistors vergrößert. Die folgende vereinfachte Darstellung veranschaulicht die strenge Proportionalität des Differenzstroms $I_D$ als Funktion der jeweiligen Gate-Source-Ansteuerspannung $U_{GS}$:

$$I_D = \beta(U_{GS} - U_T)^2 - \beta(-U_{GS} - U_T)^2$$

$$I_D = \beta(U_{GS}^2 - 2U_{GS}U_T + U_T^2 - U_{GS}^2 - 2U_{GS}U_T - U_T^2)$$

$$I_D = -\beta\, 4\, U_{GS}U_T.$$

Die Erzeugung des Steuerpotentials erfolgt in einer Vorstufe, die in dem angegebenen Aufsatz als komplementäre Kaskodestufe in Differenztechnik ausgeführt ist.

Als Nachteil erweist sich bei der bekannten Schaltungsanordnung, daß das intern erzeugte Festpotential lediglich über eine Anordnung aus komplementären Dioden und einem Source-Folger stabilisiert ist, und daher nicht ausreichend niederohmig ist.

Es ist daher Aufgabe der in den Ansprüchen gekennzeichneten Erfindung, eine verbesserte CMOS-Ausgangsstufe für den A/B-Gegentaktbetrieb anzugeben, deren internes Festpotential lastunabhängiger ist.

Neben der eigentlichen Lösung der Aufgabe erweist sich als weiterer Vorteil der Erfindung, daß die erforderliche Versorgungsspannung gegenüber der bekannten Schaltungsanordnung verkleinert werden kann, weil die Anzahl der in Reihe geschalteten Gate-Source-Strecken reduziert ist. Dies erweist sich als Vorteil, wenn die CMOS-Ausgangsstufe nach der Erfindung Teil einer größeren monolithisch integrierten Schaltungsanordnung ist, bei der nur eine Versorgungsspannung verwendet werden soll, die aus Verlustleistungsgründen möglichst niedrig sein soll.

Die Erfindung und weitere Vorteile werden nun anhand der Figur näher erläutert, die das Schaltbild eines Operationsverstärkers mit der CMOS-Ausgangsstufe nach der Erfindung zeigt.

Die Fig. zeigt eine CMOS-Ausgangsstufe k die im A/B-Gegentaktbetrieb arbeitet und die über eine Steuerleitung st mit einem Steuerpotential ud aus einer Vorstufe d angesteuert ist. Die gesamte Anordnung stellt einen CMOS-Operationsverstärker dar, dessen Vorstufe d als konventionelle Eingangs-Differenzstufe ausgebildet ist.

Der Eingang der CMOS-Ausgangsstufe k wird durch die Steuerleitung st gebildet, die mit dem Gateanschluß des ersten Transistors n1 und mit dem Gateanschluß des dazu komplementären zweiten Transistors p1 verbunden ist. Beide Transistoren bilden das komplementäre Transistorpaar kt, dessen Ausgangsströme über eine Stromspiegelanordnung und eine Stromdifferenzstufe gegeneinander geschaltet sind, die an einer Ausgangsklemme vo den Ausgangsdifferenzstrom id liefert. Der erste Transistor n1 dient auch als erster Gegentaktausgangstransistor der CMOS-Ausgangsstufe, während der dazu komplementäre zweite Gegentaktausgangstransistor pa über die beschriebene Stromspiegelanordnung mit dem Drain-Anschluß des zweiten Transistors p1 verbunden ist.

Durch den Drain-Verbindungsknoten, der mit der Ausgangsklemme v0 der CMOS-Ausgangsstufe k identisch ist, wird die hochohmige Stromdifferenzstufe gebildet. Der Source-Anschluß des ersten Transistors n1 ist mit dem ersten Festpotential u1 verbunden, das beispielsweise mit dem Masseanschluß identisch ist. Der Source-Anschluß des zweiten Transistors p1 ist mit dem zweiten Festpotential u2 verbunden, dessen Pegel zwischen dem Massepotential und der positiven Versorgungsspannung Up liegt, und intern erzeugt wird.

Das zweite Festpotential u2 ergibt sich aus dem gewählten Arbeitspunkt des ersten und zweiten Transistors n1, p1, und zwar aus der Summe ihrer Gate-Source-Spannungen (= $U_{GS}$). Diese werden in einer Referenzspannungsquelle nachgebildet, die aus der Serienschaltung eines n- und eines p-Kanal-Transistors nd, pd gebildet ist. Beide Transistoren sind jeweils als Diode geschaltet. Der Fußpunkt der mit dem konstanten Strom ik gespeisten Referenzspannungsquelle ist mit dem ersten Festpotential u1 verbunden und der Eingangsanschluß liegt am Ausgang einer Konstantstromquelle q. Durch den Arbeitspunkt und die Auslegung der Referenzspannungsquelle kann der Arbeitspunkt des ersten und zweiten Transistors n1, p1 des komplementären Transistorpaares kt nachgebildet werden, so daß das Referenzpotential am Eingangsanschluß der Referenzspannungsquelle genau dem erforderlichen zweiten Festpotential u2 entspricht.

Mittels einer Kompensationsschaltung K, die aus einer Strom-Mitkopplungsschleife (= "Bootstrapping"-Schaltung) besteht, wird erreicht, daß der Source-Anschluß des zweiten Transistors p1 die Referenzspannungsquelle nd, pd nicht belastet mit dem Referenzpotential gespeist wird. Dies ermöglicht die Kompensationsschaltung K über einen ersten und einen zweiten Stromspiegel c1, c2 wie folgt: Der Drain-Anschluß des zweiten Transistors p1 ist auf den Eingang des ersten Stromspiegels c1 geführt, der komplementär zum Leitungstyp des zweiten Transistors p1 ist. Der Ausgang des ersten Stromspiegels c1, der einen Stromverstärkungsfaktor (= erster Verhältniswert) vom Wert 2 aufweist, ist auf den Eingang des zweiten Stromspiegels c2 geschaltet, dessen erster Ausgangstransistor der zweite Gegentaktausgangstransistor pa ist und dessen zweiter Ausgangstransistor p2 Teil der Kompensationsschaltung K ist. Der Drain-Anschluß dieses zweiten Ausgangstranistors p2, der zugleich eine Stromuntersetzung im Verhältnis 2 zu 1 bewirkt, ist gemeinsam mit dem Source-Anschluß des zweiten Transistors p1 und über eine Ausgleichsleitung r mit dem Eingangsanschluß der Referenzspannungsquelle verbunden. Im Ruhezustand - das Steuerpotential ud liegt auf seinem Ruhewert - liefert der zweite Ausgangstransistor p2 die stets genauso viel Strom wie die Konstantstromquelle q. Durch die Ausgleichsleitung r fließt somit kein Ausgleichsstrom. Ändert sich das Potential am Source-Anschluß des zweiten Transistors p1, dann fließt über die Ausgleichsleitung r ein Ausgleichsstrom, der einen gleichgroßen Kompensationsstrom im Ausgang der Kompensationsschaltung K (im Transistor p2) bewirkt, und den Ausgleichsstrom dadurch kompensiert. Durch den Kompensationsstrom wird das ursprüngliche zweite Festpotential u2 somit wiederhergestellt.

Die Kompensationsschaltung K ist auf sehr einfache Weise aus einer Ergänzung der Stromdifferenzstufe gebildet. Zwischen dem zweiten Gegentaktausgangstransistor pa und dem Eingang des zweiten Stromspiegels findet eine Stromverstärkung um den Faktor 3 statt. Da im Aussteuerungsnullpunkt die Drain-Ströme der beiden Gegentaktausgangstransistoren n1, pa einander entgegengesetzt gleich sein müssen, folgt, daß im Aussteuerungsnullpunkt der Drainstrom des ersten Transistors n1 sechsmal so groß wie der Drainstrom des zweiten Transistors p1 ist. Die Steilheiten der beiden komplementären Transistoren n1, p1 unterscheiden sich also um einen zweiten Verhältniswert nämlich um den Faktor 6. Bei einer an sich beliebigen anderen Stromübersetzung der beiden Stromspiegel c1, c2 unterscheiden sich die Steilheiten entsprechend. Bevorzugte Verhältniswerte sind: 1 bis 3 für den ersten und 3 bis 10 für den zweiten Verhältniswert.

In der CMOS-Ausgangsstufe k nach der Figur sind vom p-Kanal-Leitungstyp: der zweite Transistor p1, die eine Referenzdiode pd und die Transistoren des zweiten Stromspiegels c2 sowie der Konstantstromquelle q. Vom n-Kanal-Leitungstyp sind: der erste Transistor n1, die zweite Referenzdiode nd und die Transistoren des ersten Stromspiegels c1.

Die in der Figur dargestellte Vorstufe d ist eine einfache Differenzverstärkerstufe in CMOS-Technik. Sie enthält ein p-Kanal-Differenzverstärker-Transistorpaar tp, dessen gemeinsamer Source-Anschluß über eine p-Kanal-Eingangsstromquelle eq aus der positiven Versorgungsspannung Up gespeist ist. Einem ersten und einem zweiten Gate-Anschluß d1, d2 wird die Eingangs-Differenzspannung zugeführt. Die Drain-Anschlüsse des Differenzverstärker-Transistorpaares tp sind jeweils über einen p-Kanal-Kaskodetransistor geführt, dessen jeweiliger Drain-Anschluß mit dem Ein- bzw. Ausgang eines n-Kanal-Eingangs-Stromspiegels ec, der als "aktive Last" dient, verbunden ist. Der Ausgang der aktiven Last speist die Steuerleitung st mit dem Steuerpotential ud. Zur internen Frequenzgegenkopplung ist ein mitintegrierter MOS-Kondensator c von der Ausgangsklemme vo auf einen Verbindungsknoten v in der Vorstufe d geschaltet. Der Verbindungsknoten v liegt zwischen dem Kaskodetransistor, an dem das Steuerpotential ud abgegriffen wird, und dem mit diesem Kaskodetransistor verbundenen Drain-Anschluß des Differenzverstärker-Transistorpaares tp. Ferner sind der Vorstufe d ein erstes und ein zweites Hilfspotential u3, u4 zugeführt, mit der die Eingangsstromquelle eq bzw. die Kaskodetransistoren in ihrem Arbeitspunkt festgelegt werden.

Statt der in der Figur dargestellten Vorstufe d können auch andere Schaltungen verwendet werden, beispielsweise die angesprochene komplementäre Kaskodestufe.

Die gesamte Steilheit der CMOS-Ausgangsstufe k ist außer über die beschriebene Stromverstärkung der beiden Stromspiegel c1, c2, insbesondere über den von der Konstantstromquelle q gelieferten konstanten Strom ik beliebig einstellbar. Als Steilheit ist dabei das Verhältnis von Ausgangsdifferenzstrom id und eingangsseitigem Steuerpotential ud anzusehen. Wird die Konstantstromquelle q durch einen variablen Steuerstrom iv ersetzt, dann kann die CMOS-Ausgangsstufe k auch mit Vorteil als Transkonduktanzverstärker mit beliebig einstellbarer Steilheit verwendet werden. Die jeweilige Steilheit ist direkt proportional zum Wert des variablen Steuerstromes iv. Das in der Amplitude zu regelnde Signal ist als Steuerpotential ud an die Steuerleitung st anzuschließen. In gleicher Weise ist ein analoger Multiplizierer realisierbar.

**Patentansprüche**

1. CMOS-Ausgangsstufe, die im A/B-Gegentaktbetrieb arbeitet und die über eine Steuerleitung (st) mit einem Steuerpotential (ud) aus einer Vorstufe (d) angesteuert ist,

   - die Steuerleitung (st) speist die Gate-Anschlüsse eines komplementären Transistorpaares (kt), dessen erster Transistor (n1) als erster Gegentaktausgangstransistor dient und dessen zweiter Transistor (p1) über eine zweite Stromspiegelanordnung (c2) mit dem Gate-Anschluß eines zweiten Gegentaktausgangsstransistors (pa) verbunden ist, wobei der zweite Gegentaktausgangstransistor (pa) und der zweite Transistor (p1) dem gleichen Kanalleitungstyp angehören,

   - der Source-Anschluß des ersten bzw. des zweiten Transistors (n1, p1) liegt auf einem ersten bzw. einem zweiten Festpotential (u1, u2),

   - der Drain-Verbindungsknoten (= Ausgangsklemme (vo)) des ersten und zweiten Gegentaktausgangstransistors (n1, pa) bildet eine hochohmige Stromdifferenzstufe, wobei der Drain-Strom des zweiten Gegentaktausgangstransistors (pa) proportional zum Drain-Strom des zweiten Transistors (p1) ist,

   - im gesamten Aussteuerbereich des Steuerpotentials (ud) bleiben sowohl der erste als auch der zweite Transistor (n1, p1) im Bereich ihrer jeweiligen quadratischen Strom-Spannungskennlinie $I_{DS} = \beta(U_{GS} - U_T)^2$,

   - im Aussteuerungsnullpunkt hat der Ausgangsdifferenzstrom (id) den Wert Null und

   - das zweite Festpotential (u2) ist mittels einer Referenzspannungsquelle gebildet, die in Serienschaltung einen als Diode geschalteten n-Kanal-Transistor (nd), einen als Diode geschalteten p-Kanal-Transistor (pd) und eine Konstantstromquelle (q) enthält, wobei der Fuß–punkt der Referenzspannungsquelle mit einem der Festpotentiale (u1) verbunden ist, und wobei das zweite Festpotential (u2) durch den Verbindungs-Knoten zwischen der Konstantstromquelle und der Serienschaltung der als Dioden geschalteten Transistoren (pd, nd) festgelegt wird

gekennzeichnet durch folgende Merkmale:

   - der relativ hohe Innenwiderstand der Referenzspannungsquelle ist mittels einer aktiven Kompensationsschaltung (K) kompensiert und

   - die Kompensationsschaltung (K) enthält die zweite Stromspiegelanordnung (c2) und einen ersten Stromspiegel (c1) enthaltende und mit dem Spannungsausgang der Referenzspannungsquelle verkoppelte Strom-Mitkopplungsschleife, die den jeweiligen Laststrom für den zweiten Transistor (p1) liefert.

2. CMOS-Ausgangsstufe nach Anspruch 1, gekennzeichnet durch folgende Merkmale:

   - der Drain-Anschluß des zweiten Transistors (p1) ist mit dem Eingang eines ersten Stromspiegels (c1) verbunden, dessen Ausgang mit dem Eingang eines zweiten Stromspiegels (c2), der zwei Stromausgänge aufweist, verbunden ist,

   - der erste Ausgangsstransistor des zweiten Stromspiegels (c2) dient als der zweite Gegentaktausgangstransistor (pa),

   - der zweite Ausgangsstransistor (p2) des zweiten Stromspiegels (c2) speist als Stromquelle den Source-Anschluß des zweiten Transistors (p1) und bildet den Ausgangsanschluß der Kompensationsschaltung (K),

   - die Konstantstromquelle (q) ist vom selben Kanalleitungstyp wie der zweite Stromspiegel (c2) und

   - der Eingangsanschluß der Referenzspannungsquelle ist mit dem Source-Anschluß des zweiten Transistors (p1) verbunden.

3. CMOS-Ausgangsstufe nach Anspruch 2, dadurch gekennzeichnet, daß der Ausgangsstrom der Konstantstromquelle (q) gleich dem Ruhestrom des dem zweiten Stromspiegel (c2) zugehörigen zweiten Ausgangstransistors (p2) ist und daß demgegenüber der Ausgangsruhestrom des ersten Stromspiegels (c1) einen ersten Verhältniswert und der Ruhestrom durch den ersten und zweiten Gegentaktausgangstransistor (n1, pa) einen zweiten Verhältniswert aufweist.

4. CMOS-Ausgangsstufe nach Anspruch 2, dadurch gekennzeichnet, daß der erste bzw. der zweite Transistor (n1, p1) des komplementären Transistorpaares (kt) vom p-Kanal-Typ bzw. vom n-Kanal-Typ ist.

5. Verwendung einer CMOS-Ausgangstufe als Transkonduktanzverstärker mit variabler Steilheit, wobei die CMOS-Ausgangsstufe gemäß einem der Ansprüche 1 bis 4 ausgebildet ist, gekennzeichnet durch folgende Merkmale:

   - über die Steuerleitung (st) wird als Steuerpotential (ud) ein in der Amplitude zu regelndes Spannungssignal zugeführt,

   - dem Eingangsanschluß der Referenzspannungsquelle (pd, ud) wird anstatt des konstanten Stromes (ik) ein variabler Steuerstrom (iv) zugeführt und

   - mit dem Wert des variablen Steuerstromes (iv) ist die Steilheit beliebig einstellbar.

6. CMOS-Differenzverstärker mit einer CMOS-Ausgangsstufe (k) gemäß Anspruch 2, gekennzeichnet durch folgende Merkmale:

   - die Vorstufe (d) ist eine Differenzeingangsstufe mit einem über die Source-Anschlüsse verbundenen Differenzverstärker-Transistorpaar (tp),

   - der gemeinsame Source-Anschluß ist von einer Eingangsstromquelle (eq) gespeist,

   - die Drain-Anschlüsse des Differenzverstärker-Transistorpaares (tp) sind über einen als aktive Last dienenden Stromspiegel (ec) miteinander gekoppelt und

   - das Ausgangssignal der aktiven Last dient als Steuerpotential (ud) für die CMOS-Ausgangsstufe (k).

7. CMOS-Differenzverstärker nach Anspruch 6, dadurch gekennzeichnet, daß zwischen die Drain-Anschlüsse des Differenzverstärker-Transistorpaares (tp) und die Anschlüsse der aktiven Last jeweils ein Kaskode-Transistor gleichen Leitungstyps wie das Differenzverstärker-Transistorpaar (tp) geschaltet ist und daß der Verbindungsknoten (v) zwischen dem Kaskodetransistor, an dem das Steuerpotential (ud) abgegriffen wird, und dem mit diesem Kaskodetransistor verbundenen Drain-Anschluß des Differenzverstärker-Transistorpaares (tp) über einen mitintegrierten MOS-Kondensator (c) mit dem Ausgangsanschluß (vo) der CMOS-Ausgangsstufe (k) verbunden ist.

8. CMOS-Differenzverstärker nach Anspruch 7, dadurch gekennzeichnet, daß das Differenzverstärker-Transistorpaar (tp) aus zwei identischen p-Kanal-Transistoren gebildet ist.

**Claims**

1. A class-AB push-pull CMOS output stage which is driven via a control line (st) with a drive potential (ud) from a prestage (d), wherein

   - the control line (st) feeds the gate terminals of a complementary transistor pair (kt) whose first transistor (n1) serves as a first push-pull output transistor and whose second transistor (p1) is connected to the gate terminal of a second push-pull output transistor (pa) via a second current-mirror arrangement (c2), with the second push-pull output transistor (pa) and the second transistor (p1) being of the same conductivity type;

   - the source terminals of the first and second transistors (n1, p1) are connected to a first fixed potential (u1) and a second fixed potential (u2), respectively;

   - the drain node (= output terminal (vo)) of the first and second push-pull output transistors (n1, pa) forms a high-impedance current-difference stage, with the drain current of the second push-pull output transistor (pa) being proportional to the drain current of the second transistor (p1);

   - throughout the range of the drive potential (ud), both the first transistor (n1) and the second transistor (p1) remain in the range of their respective square-law current-voltage characteristics $I_{DS} = \beta(U_{GS} - U_T)^2$;

   - at zero drive level, the differential-output current (id) has the value zero; and

   - the second fixed potential (u2) is formed by means of a reference-voltage source containing a series combination of a diode-connected n-channel transistor (nd), a diode-connected p-channel transistor (pd), and a constant-current source (q), with the low end of the reference-voltage source connected to one of the fixed potentials (u1), and the second fixed potential (u2) being determined by the node of the constant-current source and the series combination of the diode-connected transistors (pd, nd),

characterized by the following features:

- The relatively high internal resistance of the reference-voltage source is compensated for by means of an active compensation circuit (K); and

- the compensation circuit (K) comprises a positive current feedback loop containing the second current-mirror arrangement (c2) and a first current mirror (c1) and coupled to the voltage output of the reference-voltage source, said positive current feedback loop providing the respective load current for the second transistor (p1).

2. A CMOS output stage as claimed in claim 1, characterized by the following features:

- The drain terminal of the second transistor (p1) is connected to the input of a first current mirror (c1) having its output coupled to the input of a second current mirror (c2) which has two current outputs;

- the first output transistor of the second current mirror (c2) serves as the second push-pull output transistor (pa);

- the second output transistor (p2) of the second current mirror (c2) feeds as a current source the source terminal of the second transistor (p1) and forms the output terminal of the compensation circuit (K);

- the constant-current source (q) is of the same channel-conductivity type as the second current mirror (c2); and

- the input terminal of the reference-voltage source is connected to the source terminal of the second transistor (p1).

3. A CMOS output stage as claimed in claim 2, characterized in that the output current of the constant-current source (q) is equal to the quiescent current of the second output transistor (p2) of the second current mirror (c2), whereas the quiescent output current of the first current mirror (c1) has a first ratio value and the quiescent current through the first and second push-pull output transistors (n1, pa) has a second ratio value.

4. A CMOS output stage as claimed in claim 2, characterized in that the first and second transistors (n1, p1) of the complementary transistor pair (kt) are of the p-channel type and the n-channel type, respectively.

5. Use of a CMOS output stage according to any one of claims 1 to 4 as a variable-transconductance amplifier,
characterized by the following features:

- As the drive potential (ud), a voltage signal to be controlled in amplitude is applied over the control line (st);

- the input terminal of the reference-voltage source (pd, ud) is supplied with a variable control current (iv) instead of the constant current (ik), and

- with the value of the variable control current (iv), the transconductance is arbitrarily adjustable.

6. A CMOS differential amplifier comprising a CMOS output stage (k) according to claim 2,
characterized by the following features:

- The prestage (d) is a differential-input stage comprising a differential amplifier transistor pair (tp) interconnected via the source terminals;

- the common source terminal is supplied from an input current source (eq);

- the drain terminals of the differential amplifier transistor pair (tp) are coupled together via a current mirror (ec) serving as an active load, and

- the output of the active load serves as the drive potential (ud) for the CMOS output stage (k).

7. A CMOS differential amplifier as claimed in claim 6, characterized in that a respective cascode transistor of the same conductivity type as the differential amplifier transistor pair (tp) is connected between each of the drain terminals of the differential amplifier transistor pair (tp) and each of the terminals of the active load, and that the node (v) of the cascode transistor providing the drive potential (ud) and that drain terminal of the differential amplifier transistor pair (tp) which is connected to said cascode transistor is connected through an integrated MOS capacitor (c) to the output terminal (vo) of the CMOS output stage (k).

8. A CMOS differential amplifier as claimed in claim 7, characterized in that the differential amplifier transistor pair (tp) is formed from two identical p-channel transistors.


**Revendications**

1. Étage de sortie CMOS, qui fonctionne en mode push-pull A/B et qui est commandé à partir d'un étage préliminaire (d) par l'intermédiaire d'une ligne de commande (st) avec un potentiel de commande (ud), dans lequel

   - la ligne de commande (st) alimente les bornes de grille d'une paire de transistors complémentaires (kt) dont le premier transistor (n1) sert de premier transistor de sortie push-pull et dont le second transistor (p1) est relié à la borne de grille d'un second transistor de sortie push-pull (pa) par l'intermédiaire d'un second agencement de circuit à miroir de courant (c2), le second transistor de sortie push-pull (pa) et le second transistor (p1) appartenant au même type de conduction à canal,
   - les bornes de source des premier et second transistors (nl, pl) sont respectivement à un premier et un second potentiels fixes (u1, u2),
   - le noeud de jonction de drain (= borne de sortie (vo)) du premier et du second transistors de sortie push-pull (n1, pa) constituent un étage de différence de courant à impédance élevée, le courant de drain du second transistor de sortie push-pull (pa) étant proportionnel au courant de drain du second transistor (p1),
   - dans tout le domaine de réglage du potentiel de commande (ud), le premier et le second transistors (n1, p1) restent aussi bien l'un que l'autre dans la zone de leurs caractéristiques quadratiques courant-tension $I_{DS} = \beta(U_{GS} - U_T)^2$ respectives,
   - au point nul de réglage, le courant différentiel de sortie (id) a la valeur nulle et
   - le second potentiel fixe (u2) est formé au moyen d'une source de tension de référence qui contient, en montage en série, un transistor (nd) à canal N, connecté en diode, un transistor (pd) à canal P, connecté en diode, et une source de courant constant (q), tandis que la base de la source de courant de référence est reliée à l'un des potentiels fixes (u1) et que le second potentiel fixe (u2) est déterminé au moyen du noeud de jonction entre la source de courant constant et le montage en série des transistor (pd, nd) connectés en diode,

   caractérisé par les particularités suivantes :

   - la résistance interne relativement élevée de la source de tension de référence est compensée au moyen d'un circuit de compensation actif (K) et
   - le circuit de compensation (K) contient le second agencement de circuit à miroir de courant (c2) et une boucle de contre-réaction de courant qui contient un premier circuit à miroir de courant (c1) et est accouplée à la sortie de tension de la source de tension de référence et qui fournit au second transistor (p1) le courant de charge prévu à chaque instant.

2. Étage de sortie CMOS selon la revendication 1, caractérisé par les particularités suivantes :

   - la borne de drain du second transistor (p1) est reliée à l'entrée d'un premier circuit à miroir de courant (c1) dont la sortie est reliée à l'entrée d'un second circuit à miroir de courant (c2) qui comporte deux sorties de courant,
   - le premier transistor de sortie du second circuit à miroir de courant (c2) sert à constituer le second transistor de sortie push-pull (pa),
   - le second transistor de sortie (p2) du second circuit à miroir de courant (c2) alimente, en tant que source de courant, la borne de source du second transistor (p1) et constitue la borne de sortie du circuit de compensation (K),
   - la source de courant constant (q) est du même type de conduction à canal que le second circuit miroir de courant (c2) et
   - la borne d'entrée de la source de tension de référence est reliée à la borne de source du second transistor (p1).

3. Étage de sortie CMOS selon la revendication 2, caractérisé en ce que le courant de sortie de la source de courant constant (q) est égal au courant de repos du second transistor de sortie (p2) associé au second circuit à miroir de courant (c2) et en ce que, par ailleurs, le courant de repos de sortie du premier circuit à miroir de courant (c1) présente une première valeur de rapport et le courant de repos traversant le premier et le second transistors de sortie push-pull (n1, pa) présente une seconde valeur de rapport.

4. Étage de sortie CMOS selon la revendication 2, caractérisé en ce que le premier et le second transistors (n1, p1) de la paire de transistors complémentaires (kt) sont respectivement du type à canal P et du type à canal N.

5. Utilisation d'un étage de sortie CMOS en tant qu'amplificateur à transconductance à pente variable, l'étage de sortie CMOS étant réalisé selon l'une des revendication 1 à 4, caractérisée par les particularités suivantes :

- un signal de tension à régler en amplitude est appliqué en tant que potentiel de commande (ud) par l'intermédiaire de la ligne de commande (st),
- un courant de commande variable (iv) est appliqué, à la place du courant constant (ik) à la borne d'entrée de la source de tension de référence (pd, ud) et
- la pente est réglable à volonté au moyen de la valeur du courant de commande variable (iv).

6. Amplificateur différentiel CMOS comportant un étage de sortie CMOS (k) selon la revendication 2, caractérisé par les particularités suivantes :

- l'étage préliminaire (d) est un étage d'entrée différentiel comportant une paire de transistors d'amplificateur différentiel (tp) reliés par leurs bornes de source,
- la borne de source commune est alimentée par une source de courant d'entrée (eq),
- les bornes de drain de la paire de transistors d'amplificateur différentiel (tp) sont accouplées l'une à l'autre par l'intermédiaire d'un circuit à miroir de courant (ec) servant de charge active et
- le signal de sortie de la charge active sert de potentiel de commande (ud) pour l'étage de sortie CMOS (k).

7. Amplificateur différentiel CMOS selon la revendication 6, caractérisé en ce qu'entre les bornes de drain de la paire de transistors d'amplificateur différentiel (tp) et les bornes de la charge active, il est connecté, dans chaque cas, un transistor cascode respectif de même type de conduction que la paire de transistors d'amplificateur différentiel (tp) et en ce que le noeud de jonction (v) situé entre le transistor cascode sur lequel le potentiel de commande (ud) est prélevé et la borne de drain, reliée à ce transistor cascode, de la paire de transistors d'amplificateur différentiel (tp) est relié à la borne de sortie (vo) de l'étage de sortie CMOS (k) par l'intermédiaire d'un condensateur MOS (c) intégré au circuit.

8. Amplificateur différentiel CMOS selon la revendication 7, caractérisé en ce que la paire de transistors d'amplificateur différentiel (tp) est formée de deux transistors à canal P identiques.